# FASCICULE DE BREVET EUROPEEN

(11) **EP 0 843 355 B1**
(45) Date de publication et mention de la délivrance du brevet: **13.08.2008**
(21) Numéro de dépôt: 97410131.3
(22) Date de dépôt: 18.11.1997
(51) Int. Cl.: H01L 21/8249, H01L 27/06

(54) **Fabrication de circuits intégrés bipolaires/CMOS et d'un condensateur**
Herstellung von integrierten Bipolar-/CMOS-Schaltkreisen und einem Kondensator
Manufacture of integrated bipolar/CMOS circuits and a capacitor

(30) Priorité: 19.11.1996 FR 9614410
(43) Date de publication de la demande: 20.05.1998
(73) Titulaire: STMicroelectronics S.A., 92120 Montrouge (FR)
(72) Inventeur: Gris, Yvon, 38210 Tullins (FR)
(74) Mandataire: de Beaumont, Michel

(56) Documents cités:
- EP-A- 0 139 019
- EP-A- 0 435 257
- EP-A- 0 495 329
- EP-A- 0 746 032
- US-A- 5 045 484
- "Simplified Bipolar in Bi-CMOS" IBM TECHNICAL DISCLOSURE BULLETIN, vol. 33, no. 7, décembre 1990, NEW YORK US, pages 401-402, XP000108500
- SCHARF B: "BICMOS PROCESS DESIGN FOR MIXED-SIGNAL APPLICATIONS" PROCEEDINGS OF THE INTERNATIONAL SYMPOSIUM ON CIRCUITS AND SYSTEMS, SAN DIEGO, MAY 10 - 13, 1992, vol. 6 OF 6, 10 mai 1992, INSTITUTE OF ELECTRICAL AND ELECTRONICS ENGINEERS, pages 2683-2686, XP000338781
- PATENT ABSTRACTS OF JAPAN vol. 95, no. 1, 28 février 1995 & JP 06 291262 A (SONY CORP), 18 octobre 1994,

## Description

La présente invention concerne une filière de fabrication de circuits intégrés susceptibles de contenir notamment des composants bipolaires et MOS complémentaires (CMOS). Ce type de filière est habituellement appelé filière BICMOS.

Le document EP-A-0 435 257 décrit un procédé de fabrication d'un circuit intégré comprenant des transistors MOS complémentaires et un transistor bipolaire de type NPN, comprenant les étapes suivantes :
former une couche épitaxiée de type N sur un substrat de type P, une couche enterrée étant prévue à l'emplacement du transistor bipolaire,
former une couche d'oxyde épais aux emplacements autres que les emplacements des caissons des transistors MOS, d'une région de collecteur du transistor bipolaire et d'une région de base-émetteur du transistor bipolaire,
former les transistors MOS au sein du procédé,
recouvrir l'ensemble de la structure d'une couche de protection comprenant une première couche d'oxyde de silicium et une première couche de nitrure de silicium, ouvrir la couche de protection à l'emplacement d'émetteur-base du transistor bipolaire, former une première couche de silicium polycristallin, une deuxième couche de nitrure de silicium et une deuxième couche d'oxyde d'encapsulation,
ouvrir la couche de nitrure de silicium au centre de la région d'émetteur-base du transistor bipolaire pour convertir la couche de silicium polycristallin en oxyde de silicium
implanter un dopant de type P pour former la base extrinsèque du transistor bipolaire, éliminer l'oxyde de silicium au centre de la région d'émetteur-base du transistor bipolaire
former une troisième couche d'oxyde de silicium
implanter un dopant de type P pour former la base intrinsèque du transistor bipolaire, déposer une quatrième couche d'oxyde de silicium,
déposer une deuxième couche de silicium polycristallin, graver de façon anisotrope la deuxième couche de silicium polycristallin pour laisser en place des espaceurs dans les portions verticales de celle-ci, et éliminer les parties apparentes de la troisième et
quatrième couche d'oxyde de silicium,
déposer une troisième couche de silicium polycristallin dopée de type N,
déposer une couche isolante planarisée et faire diffuser le dopant de la troisième couche de silicium polycristallin pour former l'émetteur du transistor bipolaire, et
procéder aux métallisations.

Un objet de la présente invention est de prévoir une telle filière dans laquelle les dimensions d'un élément dessiné sur un masque peuvent être d'une dimension inférieure ou égale à 0,4 µm, par exemple 0,2 à 0,35 µm.

Un objet plus particulier de la présente invention est de prévoir une telle filière dans laquelle les propriétés des composants de type MOS et celles des composants de type bipolaire sont optimisées.

Un autre objet de la présente invention est de prévoir une telle filière qui soit compatible avec des filières connues de fabrication de composants CMOS.

Un autre objet de la présente invention est de prévoir une telle filière qui soit aussi simple que possible pour atteindre les résultats visés.

Un autre objet de la présente invention est de prévoir une telle filière qui se prête à la fabrication de condensateurs à forte capacité par unité de surface.

Pour atteindre ces objets, la présente invention prévoit un procédé de fabrication dans lequel on réalise successivement les couches enterrées des transistors bipolaires, les transistors CMOS, les transistors bipolaires, puis les interconnexions, pour décorréler les caractéristiques des transistors MOS de celles des transistors bipolaires et optimiser chacun de ces composants. Après formation des transistors MOS, une couche de protection permet de protéger les transistors MOS pendant la formation des transistors bipolaires. Cette même couche de protection est ensuite utilisée comme masque pour la formation de zones siliciurées.

Plus particulièrement, la présente invention prévoit un procédé de fabrication d'un circuit intégré comprenant des transistors MOS complémentaires et un transistor bipolaire de type NPN, comportant les étapes suivantes :
former une couche épitaxiée de type N sur un substrat de type P, une couche enterrée étant prévue au moins à l'emplacement du transistor bipolaire,
former une couche d'oxyde épais aux emplacements autres que les emplacements des caissons des transistors MOS, d'une région de puits collecteur du transistor bipolaire et d'une région de base-émetteur du transistor bipolaire,
former les transistors MOS et le puits collecteur du transistor bipolaire,
recouvrir l'ensemble de la structure d'une couche de protection comprenant une première couche d'oxyde de silicium et une première couche de nitrure de silicium,
ouvrir la couche de protection à l'emplacement d'émetteur-base du transistor bipolaire,
former une première couche de silicium polycristallin ou amorphe dopée de type P, une deuxième couche de nitrure de silicium et une deuxième couche d'oxyde d'encapsulation,
ouvrir ces trois dernières couches au centre de la région d'émetteur-base du transistor bipolaire,
faire diffuser le dopant contenu dans la première couche de silicium dans la couche épitaxiée sous-jacente, pour former la base extrinsèque du transistor bipolaire,
implanter un dopant de collecteur de type N,
implanter un dopant de type P pour former la base intrinsèque du transistor bipolaire,
déposer une troisième couche de nitrure de silicium, déposer une deuxième couche de silicium polycristallin, graver de façon anisotrope la deuxième couche de silicium polycristallin pour laisser en place des espaceurs dans les portions verticales de celle-ci, et éliminer les parties apparentes de la troisième couche de nitrure de silicium,
déposer une troisième couche de silicium polycristallin dopée de type N et faire diffuser le dopant pour former l'émetteur du transistor bipolaire,
déposer une couche isolante planarisée, et
procéder aux métallisations.

Selon un mode de réalisation de la présente invention, la première couche d'oxyde de silicium a une épaisseur de l'ordre de 20 nm et les première à troisième couche de nitrure de silicium ont une épaisseur de l'ordre de 30 nm.

Selon un mode de réalisation de la présente invention, la première couche de silicium a une épaisseur de l'ordre de 200 nm et la deuxième couche d'oxyde de silicium a une épaisseur de l'ordre de 300 nm.

Selon un mode de réalisation de la présente invention, la première couche de silicium est obtenue par dépôt de silicium amorphe non dopé puis par implantation superficielle de BF₂.

Selon un mode de réalisation de la présente invention, lors de l'étape d'ouverture de la première couche de silicium polycristallin ou amorphe dopée de type P, de la deuxième couche de nitrure de silicium et de la deuxième couche d'oxyde d'encapsulation, il est formé dans la deuxième couche d'oxyde d'encapsulation une ouverture plus étendue que dans la deuxième couche de nitrure de silicium, d'où il résulte que, lors du dépôt de la troisième couche de nitrure de silicium, celle-ci présente une surface de contact plus importante avec la deuxième couche de nitrure de silicium.

Selon un mode de réalisation de la présente invention, ce procédé comprend en outre, avant l'étape de dépôt de la troisième couche de silicium polycristallin dopée de type N, l'étape consistant à effectuer une ouverture dans la deuxième couche d'oxyde d'encapsulation, pour exposer une portion de la deuxième couche de nitrure de silicium, d'où il résulte que, au niveau de cette ouverture, les première et troisième couches de silicium polycristallin forment un condensateur dont le diélectrique est constitué d'une portion de la deuxième couche de nitrure de silicium.

Selon un mode de réalisation de la présente invention, ladite ouverture est formée au-dessus d'une zone d'oxyde épais.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 10 sont des vues en coupe schématiques illustrant des étapes successives de fabrication d'un mode de réalisation d'un transistor MOS à canal N, d'un transistor MOS à canal P et d'un transistor bipolaire de type NPN selon la présente invention ; et
la figure 11 est une vue en coupe schématique agrandie d'un transistor bipolaire de type NPN et d'un condensateur obtenus selon la présente invention.

Comme cela est usuel dans le domaine de la représentation des composants semiconducteurs, les diverses vues en coupe ne sont pas tracées à l'échelle. Les dimensions latérales et transversales des diverses couches et régions sont arbitrairement dilatées ou rétrécies pour faciliter le tracé des figures.

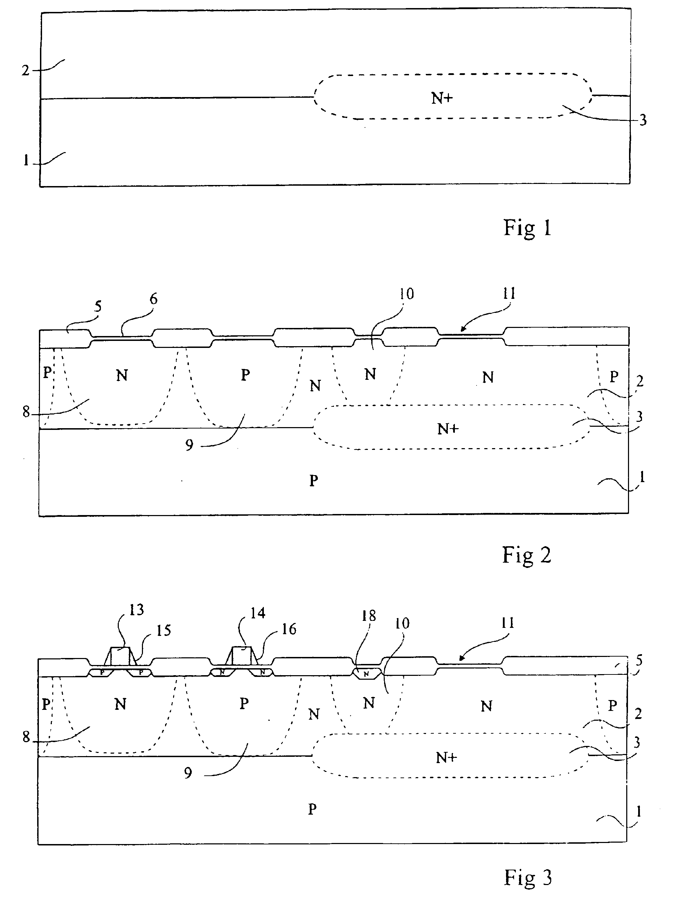

De façon générale dans la suite de la description, on désignera le côté gauche des figures 1 à 10 dans lequel est formé un composant CMOS par l'appellation côté CMOS et le côté droit de ces figures dans lequel est formé un transistor bipolaire de type NPN par l'appellation côté bipolaire. Dans ce qui suit, on décrit la fabrication d'un transistor MOS à canal N, d'un transistor MOS à canal P et d'un transistor bipolaire de type NPN. Bien entendu, dans une réalisation pratique, on formera simultanément de nombreux composants identiques, ainsi qu'éventuellement d'autres types de composants élémentaires.

Selon un aspect de la présente invention, les étapes initiales correspondent à des étapes connues de fabrication de circuits intégrés CMOS de très petites dimensions (dimension minimum, ou dimension de grille, inférieure à 0,35 µm).

Comme le représente la figure 1, on part d'un substrat 1 de type P sur lequel est formée une couche épitaxiale 2 de type N. Cette couche épitaxiale est relativement mince, par exemple d'une épaisseur de l'ordre de 1 à 1,2 µm.

Avant la croissance de la couche épitaxiale, on prévoit si on le souhaite des couches enterrées de types appropriés dans les zones où doivent être formés des caissons N ou P de transistors CMOS et l'on forme une couche enterrée 3 de type N⁺ du côté bipolaire.

Comme le représente la figure 2, du côté MOS, on délimite les régions des transistors MOS par des ouvertures dans une couche d'oxyde épais 5 formée par toute technique connue. On implante, à travers l'oxyde épais ou une région d'oxyde mince 6 formée dans les ouvertures, des caissons 8 de type N et des caissons 9 de type P, de façon classique. Ces caissons sont par exemple formés par une succession de trois implantations dont l'une traverse l'oxyde épais 5 dans des régions non-masquées. Ces caissons N et P sont destinés respectivement à des transistors MOS à canal P et à des transistors MOS à canal N. Le niveau de dopage en surface (quelques 10¹⁶ at./cm³) détermine la tension de seuil des transistors. Dans le cas général, les caissons P (associés à une couche enterrée P⁺) sont en contact électrique avec le substrat P. On pourra toutefois prévoir de former certains au moins des caissons P sur une couche enterrée de type N. Les caissons N sont complètement isolés puisqu'ils débouchent dans le substrat P et ils sont isolés latéralement par des régions P formées comme les caissons P.

Simultanément, côté bipolaire, on délimite dans l'oxyde épais 5 une région dans laquelle sera formée une diffusion profonde de reprise de contact de collecteur ou puits collecteur 10 rejoignant la couche enterrée 3. Ce puits collecteur est formé par au moins certaines des implantations réalisées pour former le caisson 8 de type N, ou bien par une implantation spécifique de type N⁺. Ce puits collecteur peut aussi être formé ultérieurement en même temps que les sources et drains des transistors MOS à canal N. Egalement, on délimite dans l'oxyde épais une zone 11 dans laquelle seront formés la base et l'émetteur d'un transistor bipolaire de type NPN. Pendant les diverses implantations de caissons N et P, cette zone 11 est masquée.

Comme le représente la figure 3, du côté MOS, on forme de façon classique des grilles isolées 13 et 14 des transistors MOS ; on réalise des premières implantations (LDD) ; on forme des espaceurs 15 et 16 ; et on réalise des implantations de drains et de sources. Dans le caisson 8, les implantations sont de type P et, dans le caisson 9, les implantations sont de type N. En même temps que l'on fait les implantations de sources et de drains des transistors à canal N dans les caissons P, on réalise une diffusion de type N fortement dopée 18 à la surface du puits collecteur 10 pour améliorer la prise de contact ultérieure.

On effectue ensuite un recuit thermique rapide (1025°C).

Après cette étape, à la fin de laquelle l'essentiel des transistors MOS a été réalisé (sauf les éventuelles siliciurations de prise de contact et les métallisations), on procède à la réalisation du transistor bipolaire de type NPN.

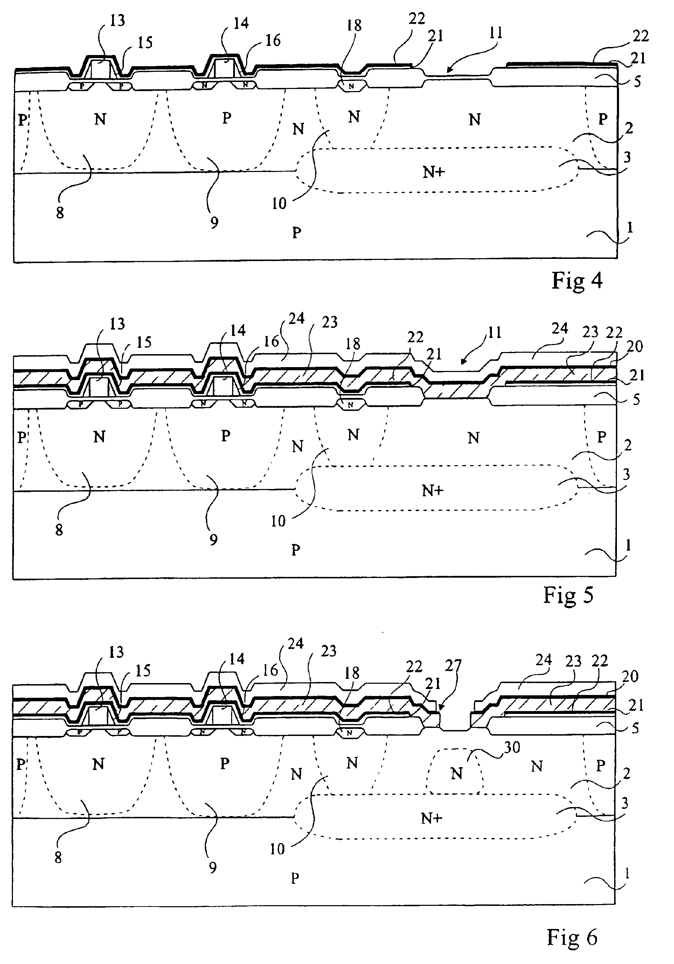

A l'étape illustrée en figure 4, on dépose sur l'ensemble de la structure, par voie chimique en phase vapeur, une double couche de protection comprenant une couche d'oxyde de silicium 21 ayant par exemple une épaisseur de l'ordre de 20 nm suivie d'une couche de nitrure de silicium 22 ayant par exemple une épaisseur de l'ordre de 30 nm. Cette couche 21-22 est ouverte dans la zone 11 où l'on souhaite former la région émetteur-base d'un transistor bipolaire. On notera que le positionnement de cette ouverture n'est pas critique puisqu'elle s'arrête sur des régions d'oxyde épais.

A l'étape illustrée en figure 5, on dépose sur l'ensemble de la structure une couche de silicium 23 ayant par exemple une épaisseur de l'ordre de 200 nm suivie d'une couche de nitrure de silicium 20 ayant par exemple une épaisseur de l'ordre de 30 nm et d'une couche d'oxyde d'encapsulation 24 ayant par exemple une épaisseur de l'ordre de 300 nm.

La couche de silicium 23 doit être dopée de type P puisqu'elle servira comme on le verra ci-après de source de dopage pour la base extrinsèque du transistor NPN et sera appelée silicium polycristallin de base. Bien qu'elle soit désignée sous l'appellation silicium polycristallin, il pourra aussi s'agir de tout type de couche de silicium déposé, par exemple du silicium amorphe. De préférence, selon un aspect de la présente invention, on procède d'abord au dépôt d'une couche 23 de silicium polycristallin ou amorphe non dopé et l'on procède ensuite à une implantation d'un dopant de type P dans cette couche. De préférence, on implante du bore sous forme de BF₂ à très forte dose (10¹⁵ à 10¹⁶ at./cm²) et à faible énergie de sorte que le bore implanté se concentre dans la partie supérieure de la couche en évitant toute implantation de bore dans le substrat de silicium sous-jacent dans la région 11.

A l'étape illustrée en figure 6, on procède à une ouverture des couches 24, 20 et 23 dans la partie centrale de la région 11. Cette ouverture a par exemple une largeur comprise entre 0,4 et 0,8 µm et pénètre dans le silicium monocristallin de moins de 50 nm. La gravure de la couche d'oxyde de silicium 24 est de préférence réalisée de sorte que, après gravure, cette couche soit légèrement en retrait par rapport au contour de l'ouverture formée dans la couche de nitrure de silicium 20. Ceci est relativement simple à obtenir en jouant sur les paramètres de gravure (pression, gaz...) Il apparaît ainsi une marche 27 dans la zone d'ouverture de la couche de nitrure de silicium 20.

On procède ensuite à une implantation d'un dopant de type N pour définir le collecteur 30 du transistor NPN. Ce collecteur est donc auto-aligné sur l'ouverture. L'implantation N est réalisée à dose moyenne et forte énergie (par exemple, 10¹² à 10¹⁴ at./cm² sous 500 keV). On obtient ainsi une région effective de collecteur d'étendue latérale limitée sensiblement égale à celle de la base intrinsèque qui est formée ensuite. Ceci contribue à l'obtention d'un transistor NPN de faible capacité parasite entre collecteur et base extrinsèque. L'implantation est optimisée (par exemple, par implantations successives) pour que le profil du collecteur fournisse le meilleur compromis possible entre, d'une part, la résistance de collecteur et le temps de transit dans ce collecteur et, d'autre part, l'obtention de tensions de claquage suffisamment élevées émetteur-collecteur (typiquement 4 volts) et base-collecteur et d'une faible capacité base-collecteur. On notera aussi que cette implantation de collecteur permet de choisir au préalable une couche épitaxiée 2 de dopage et d'épaisseur propres à optimiser les transistors CMOS et d'optimiser ensuite indépendamment les caractéristiques des transistors NPN. Notamment, cette couche épitaxiée pourra être plus épaisse que si elle devait servir directement de couche de collecteur du transistor NPN.

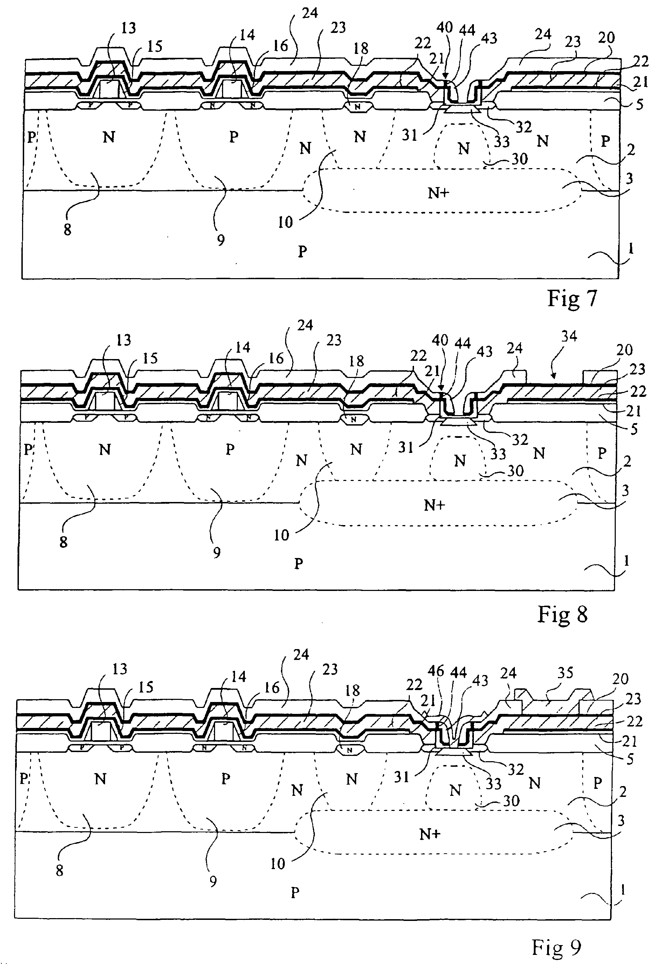

Comme le représente la figure 7, après élimination de la résine de masquage, on procède à une oxydation thermique pendant laquelle il se forme une mince couche d'oxyde thermique 31 d'une épaisseur de l'ordre de 5 à 10 nm et pendant laquelle le bore contenu dans la couche de silicium polycristallin 23 commence à diffuser dans la couche épitaxiée sous-jacente pour former une région de base extrinsèque 32 ayant par exemple une profondeur de jonction de l'ordre de 100 nm. Cette diffusion est ensuite complétée par le recuit final de la structure bipolaire. On procède alors à une implantation de type P à travers l'oxyde 31 pour former une région de base intrinsèque 33 au centre de l'ouverture dans les couches 23, 20 et 24. Cette base intrinsèque est de préférence implantée au bore à faible énergie (par exemple, 10¹³ at./cm² sous 5 keV). Le contact avec le silicium polycristallin 23 résulte de la diffusion latérale du bore du silicium polycristallin.

On procède alors à un dépôt uniforme d'une nouvelle couche mince 40 de nitrure de silicium (30 nm) puis d'une couche de silicium polycristallin (100 nm). La couche de silicium polycristallin est ensuite gravée de façon anisotrope de façon qu'il n'en demeure que des espaceurs 43 sur les flancs de l'ouverture ménagée dans les couches 23, 20 et 24. On procède ensuite à une gravure uniforme de la couche de nitrure de silicium 40, de sorte que du nitrure de silicium reste en place seulement dans les régions 44 où il est protégé de la gravure (chimique ou plasma) par les espaceurs 43 de silicium polycristallin. L'ensemble du nitrure 44 et des espaceurs 43 définit donc une ouverture plus petite que l'ouverture initialement formée dans les couches 23, 20 et 24 pour la définition de la base intrinsèque. Cette ouverture plus petite est l'ouverture d'émetteur. Si les espaceurs ont une largeur de l'ordre de 150 nm chacun, cette petite ouverture a une largeur de l'ordre de 0,5 µm.

Selon un aspect de la présente invention, la nouvelle couche mince de nitrure de silicium 40 se "soude" pendant son dépôt aux parties apparentes du contour de l'ouverture formée dans la couche de nitrure de silicium 20. La prévision de la marche 27 susmentionnée favorise l'adhérence entre les deux couches de nitrure 20 et 40, de même qu'un nettoyage soigné de la structure avant le dépôt de la couche 40.

Un avantage de la prévision de la couche de nitrure de silicium 20 résulte de cette "soudure" avec la couche de nitrure de silicium 40 qui entraîne que toute pénétration de produit de gravure ou toute surgravure plasma à l'interface verticale entre la portion de nitrure de silicium 44 et la couche d'oxyde de silicium 24 est bloquée par cette couche de nitrure 40. On évite ainsi tout risque de court-circuit entre la couche de silicium polycristallin 23 et des couches conductrices ultérieures, et notamment la couche de silicium polycristallin 46 qui sera décrite ci-après.

A l'étape illustrée en figure 8, une portion de la couche d'oxyde de silicium 24 est éliminée à un emplacement 34 pour dégager une portion de la couche de nitrure de silicium 20, de préférence au-dessus d'une zone d'oxyde épais 5.

A l'étape illustrée en figure 9, la couche mince d'oxyde 31 au fond de l'ouverture, qui avait servi de protection pendant l'implantation d'émetteur (bore) et d'arrêt de gravure de la couche de nitrure de silicium 40, est soigneusement nettoyée, par exemple dans un bain d'acide fluorhydrique dilué. On dépose une couche de silicium polycristallin fortement dopé de type N qui est ensuite gravée pour laisser en place une région 46 qui pénètre dans l'ouverture d'émetteur et une région 35 qui recouvre l'ouverture 34. Cette région 35 de la couche de silicium polycristallin dopé forme une électrode d'un condensateur dont l'autre électrode correspond à une région du silicium polycristallin de base 23 qui sera gravée lors d'une étape ultérieure. Ceci permet de former des condensateurs de forte capacité étant donné la constante diélectrique élevée du nitrure de silicium et la faible épaisseur (de l'ordre de 30 nm) de la couche de nitrure de silicium 30.

On notera que, pendant les étapes de fabrication du transistor NPN, les régions où ont été formés les transistors MOS sont protégées par la couche d'oxyde 21, la couche de nitrure 22, la couche de silicium polycristallin de base 23, la couche de nitrure 20 et la couche d'oxyde 24. Cet empilement de couches assure une protection très efficace contre toute pollution éventuelle et contre toute traversée par les dopants implantés pour la formation du transistor bipolaire.

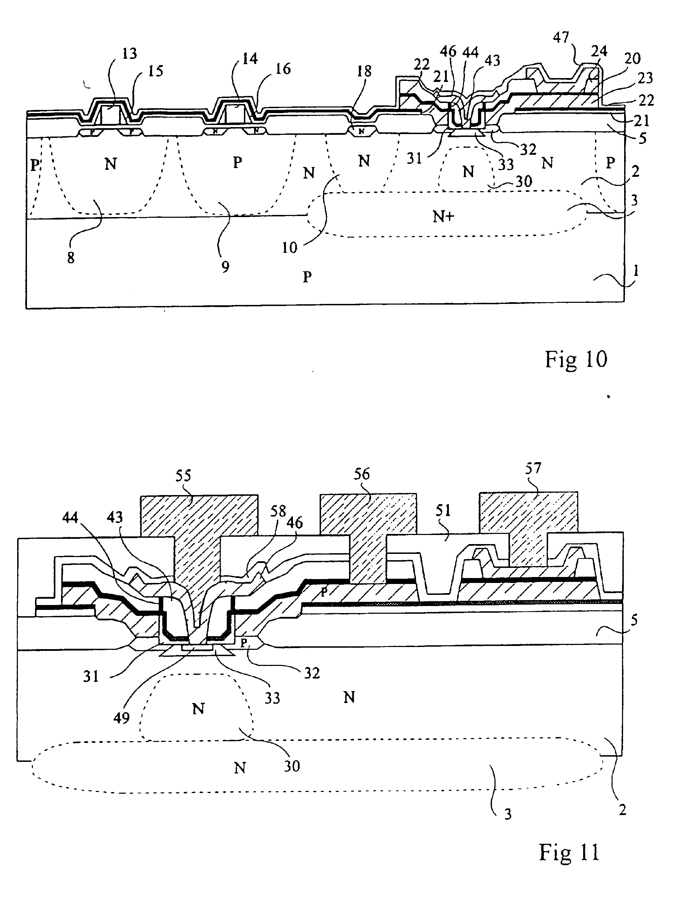

A l'étape illustrée en figure 10, on a éliminé les couches d'oxyde 24, de nitrure 20 et de silicium polycristallin de base 23 en dehors de la région d'émetteur-base du transistor bipolaire et d'autres régions éventuelles comportant des dispositifs utilisant des portions de la couche de silicium polycristallin de base 23 (résistances, capacités...) et notamment la région où l'on a formé le condensateur à diélectrique en nitrure de silicium. Puis l'on dépose une couche d'oxyde de silicium d'encapsulation 47.

Après cela, on procède à un recuit de pénétration du dopant contenu dans la couche de silicium polycristallin 46 au centre de la région de base du transistor pour former son émetteur 49 de type N. Les recuits associés au transistor bipolaire assurent une réactivation électrique des dopants et conduisent à des profondeurs de jonction de l'ordre de 60 nm. Les recuits sont du type recuit thermique rapide et/ou au four. Le traitement thermique (30 s, 1000°C) est plus léger que pour les transistors MOS qui ne sont donc pas affectés.

On élimine ensuite les couches d'oxyde de silicium d'encapsulation 47, de nitrure de silicium 22 et d'oxyde de silicium de protection 21 au-dessus des zones actives et/ou de silicium polycristallin que l'on souhaite siliciurer et un siliciure métallique est formé sélectivement au-dessus des régions exposées de silicium mono et polycristallin.

La figure 11 représente à plus grande échelle la structure finale de la région d'émetteur-base du transistor bipolaire et du condensateur obtenus par le procédé selon la présente invention.

On a procédé au dépôt d'une couche isolante de planarisation 51 par tout procédé connu, par exemple par dépôt d'une couche de verre dopé au bore et au phosphore (BPSG) et recuit, puis on a ouvert cette couche et d'éventuelles couches sous-jacentes aux emplacements où l'on veut prendre des contacts. On a seulement représenté les contacts d'émetteur 55, de base 56, et d'une électrode de condensateur 57.

Dans un mode de réalisation particulier, et pour donner un exemple d'ordres de grandeur, on pourra choisir de réaliser une structure avec les données numériques suivantes (où e désigne une épaisseur, et Cs une concentration superficielle ou une concentration moyenne pour une couche homogène) :

| | |
|---|---|
| substrat 1 | Cs = 10¹⁵ at./cm³, |
| couche épi 2 | Cs = 10¹⁶ at./cm³, e = 0,8 à 1,4 µm, |
| couche enterrée 3 | Cs = 10²⁰ at./cm³, |
| oxyde 5 | e = 0,5 µm, |
| sources et drains N ou P | Cs = 10²⁰ at./cm³, e = 0,15 µm. |

Le procédé de fabrication selon la présente invention, tout en étant parfaitement compatible avec les filières existantes de fabrication de transistors CMOS à haute définition, permet de réaliser un transistor bipolaire dont les régions de collecteur, de base intrinsèque et d'émetteur sont auto-alignées et dans lequel les risques de court-circuit émetteur-base sont pratiquement éliminés, quel que soit le traitement utilisé pour nettoyer la fenêtre d'émetteur. La même couche de nitrure de silicium sert à éviter les risques de court-circuit et sert de diélectrique de condensateur formé entre des portions de silicium polycristallin de base et d'émetteur

Ce transistor bipolaire présente de nombreux avantages. Ses performances ne souffrent pas de la présence des transistors CMOS. Il peut en particulier être utilisé aux radiofréquences (fréquence de coupure supérieure à 40 GHz). La très forte transconductance et le faible bruit du transistor bipolaire le rendent apte à des applications analogiques. En particulier, le contact de base (en silicium polycristallin P⁺) permet une forte réduction de la résistance de base d'où un facteur de bruit RF intéressant. Ainsi, le transistor bipolaire peut être utilisé en lieu et place de certains transistors AsGa avec un coût moindre et la possibilité de l'associer sur une même puce à un circuit CMOS très performant.

L'homme de l'art notera que d'autres composants peuvent être imaginés en utilisant la filière selon la présente invention et que celle-ci est susceptible de diverses variantes et modifications. Notamment, les diverses valeurs numériques indiquées l'ont été uniquement à titre d'exemple. De plus divers composants élémentaires pourront être réalisés avec ou sans couche enterrée de l'un ou l'autre type de conductivité.

## Revendications

1. Procédé de fabrication d'un circuit intégré comprenant des transistors MOS complémentaires et un transistor bipolaire de type NPN, comprenant les étapes suivantes :
former une couche épitaxiée (2) de type N sur un substrat (1) de type P, une couche enterrée (3) étant prévue au moins à l'emplacement du transistor bipolaire,
former une couche d'oxyde épais aux emplacements autres que les emplacements des caissons (8, 9) des transistors MOS, d'une région de puits collecteur (10) du transistor bipolaire et d'une région (11) de base-émetteur du transistor bipolaire,
former les transistors MOS et le puits collecteur (10) du transistor bipolaire,
recouvrir l'ensemble de la structure ainsi obtenue d'une couche de protection comprenant une première couche d'oxyde de silicium (21) et une première couche de nitrure de silicium (22),
ouvrir la couche de protection à l'emplacement d'émetteur-base du transistor bipolaire,
former une première couche de silicium polycristallin ou amorphe (23) dopée de type P, une deuxième couche de nitrure de silicium (20) et une deuxième couche d'oxyde d'encapsulation (24),
ouvrir ces trois dernières couches (23, 20, 24) au centre de la région d'émetteur-base du transistor bipolaire,
faire diffuser le dopant contenu dans la première couche de silicium (23) dans la couche épitaxiée sous-jacente, pour former la base extrinsèque du transistor bipolaire,
implanter un dopant de collecteur de type N (30),
implanter un dopant de type P (33) pour former la base intrinsèque du transistor bipolaire,
déposer une troisième couche de nitrure de silicium (40), déposer une deuxième couche de silicium polycristallin (43), graver de façon anisotrope la deuxième couche de silicium polycristallin pour laisser en place des espaceurs dans les portions verticales de celle-ci, et éliminer les parties apparentes de la troisième couche de nitrure de silicium,
déposer une troisième couche de silicium polycristallin (46) dopée de type N et faire diffuser le dopant pour former l'émetteur du transistor bipolaire,
déposer une couche isolante planarisée (51), et
procéder aux métallisations (53-56).

2. Procédé selon la revendication 1, **caractérisé en ce que** la première couche d'oxyde de silicium (21) a une épaisseur de l'ordre de 20 nm et les première à troisième couche de nitrure de silicium (22, 20, 40) ont une épaisseur de l'ordre de 30 nm.

3. Procédé selon la revendication 1, **caractérisé en ce que** la première couche de silicium (23) a une épaisseur de l'ordre de 200 nm et la deuxième couche d'oxyde de silicium (24) a une épaisseur de l'ordre de 300 nm.

4. Procédé selon la revendication 1, **caractérisé en ce que** la première couche de silicium (23) est obtenue par dépôt de silicium amorphe non dopé puis par implantation superficielle de BF₂.

5. Procédé selon la revendication 1, **caractérisé en ce que** lors de l'étape d'ouverture de la première couche de silicium polycristallin ou amorphe (23) dopée de type P, de la deuxième couche de nitrure de silicium (20) et de la deuxième couche d'oxyde d'encapsulation (24), il est formé dans la deuxième couche d'oxyde d'encapsulation (24) une ouverture plus étendue que dans la deuxième couche de nitrure de silicium (20), d'où il résulte que, lors du dépôt de la troisième couche de nitrure de silicium (40), celle-ci présente une surface de contact plus importante avec la deuxième couche de nitrure de silicium (20).

6. Procédé selon la revendication 1, **caractérisé en ce qu'**il comprend en outre, avant l'étape de dépôt de la troisième couche de silicium polycristallin (46) dopée de type N, l'étape consistant à effectuer une ouverture dans la deuxième couche d'oxyde d'encapsulation (24), pour exposer une portion de la deuxième couche de nitrure de silicium (20), d'où il résulte que, au niveau de cette ouverture, les première (23) et troisième (46) couches de silicium polycristallin forment un condensateur dont le diélectrique est constitué d'une portion de la deuxième couche de nitrure de silicium (20).

7. Procédé selon la revendication 6, **caractérisé en ce que** ladite ouverture est formée au-dessus d'une zone d'oxyde épais (5).

## Claims

1. A method for fabricating an integrated circuit including complementary MOS transistors and a bipolar transistor of NPN type, including the following steps:
forming an N-type epitaxial layer (2) on a P-type substrate (1), a buried layer (3) being provided at least at the location of the bipolar transistor,
forming a thick oxide layer at the locations other than the locations of the wells (8, 9) of the MOS transistors, of a collector well region (10) of the bipolar transistor and of a base-emitter region (11) of the bipolar transistor,
forming the MOS transistors and the collector well (10) of the bipolar transistor,
covering the entire obtained structure with a protection layer including a first layer of silicon oxide (21) and a first layer of silicon nitride (22),
opening the protection layer at the base-emitter location of the bipolar transistor,
forming a first P-type doped layer of polysilicon or amorphous silicon (23), a second layer of silicon nitride (20) and a second layer of encapsulation oxide (24),
opening these last three layers (23, 20, 24) at the center of the emitter-base region of the bipolar transistor,
diffusing the doping contained in the first silicon layer (23) in the underlying epitaxial layer, to form the extrinsic base of the bipolar transistor,
implanting an N-type collector doping (30),
implanting a P-type doping (33) to form the intrinsic base of the bipolar transistor,
depositing a third silicon nitride layer (40), depositing a second layer of polysilicon (43), anisotropically etching the second polysilicon layer to leave in place spacers in the vertical portions thereof, and removing the apparent parts of the third layer of silicon nitride,
depositing a third N-type doped polysilicon layer (46) and diffusing the doping to form the emitter of the bipolar transistor,
depositing a planarized insulating layer (51), and
performing the metallizations (53-56).

2. A method according to claim 1, **characterized in that** the first layer of silicon oxide (21) has a thickness of around 20 nm and the first to third silicon nitride layers (22, 20, 40) have a thickness of around 30 nm.

3. A method according to claim 1, **characterized in that** the first silicon layer (23) has a thickness of around 200 nm and the second silicon oxide layer (24) has a thickness of around 300 nm.

4. A method according to claim 1, **characterized in that** the first silicon layer (23) is obtained by deposition of undoped amorphous silicon, and then by superficial implant of BF₂.

5. A method according to claim 1, **characterized in that** during the step of opening of the first P-type doped polysilicon or amorphous silicon layer (23), of the second silicon nitride layer, (20) and of the second encapsulation oxide layer (24), an opening wider than in the second silicon nitride layer (20) is formed in the encapsulation oxide layer (24), whereby, upon deposition of the third silicon nitride layer (40), this layer has a larger contact surface area with the second silicon nitride layer (20).

6. A method according to claim 1, **characterized in that** it further includes, before the step of deposition of the third N-type doped polysilicon layer (46), the step consisting of performing an opening in the second encapsulation oxide layer (24), to expose a portion of the second silicon nitride layer (20), whereby, at the level of this opening, the first (23) and third (46) polysilicon layers form a capacitor, the dielectric of which is formed of a portion of the second silicon nitride layer (20) .

7. A method according to claim 6, **characterized in that** this opening is formed above a thick oxide area (5).

## Patentansprüche

1. Verfahren zum Herstellen einer integrierten Schaltung einschließlich komplementärer MOS-Transistoren und eines Bipolartransistors vom npn-Typ, umfassend die folgenden Schritte:
Bilden einer epitaktischen Schicht vom n-Typ (2) auf einem Substrat vom p-Typ (1), wobei eine vergrabene Schicht (3) zumindest an der Stelle des Bipolartransistors vorgesehen ist,
Bilden einer dicken Oxidschicht an den anderen Stellen der Potenzialtöpfe (8, 9) der MOS-Transistoren, eines Kollektor-Potenzialtopfbereichs (10) des Bipolartransistors und eines Basis-Emitter-Bereichs (11) des Bipolartransistors,
Bilden der MOS-Transistoren und des Kollektorpotenzialtopfes (10) des Bipolartransistors,
Bedecken der gesamten erlangten Struktur mit einer Schutzschicht umfassend eine erste Schicht aus Siliziumoxid (21) und eine erste Schicht aus Siliziumnitrid (22),
Öffnen der Schutzschicht an der Basis-Emitter-Stelle des Bipolartransistors,
Bilden einer ersten p-dotierten Schicht aus Polysilizium oder amorphem Silizium (23), einer zweiten Schicht aus Siliziumnitrid (20) und einer zweiten Schicht eines Verkapselungsoxids (24),
Öffnen dieser letzten drei Schichten (23, 20, 24) an der Mitte des Emitter-Basis-Bereichs des Bipolartransistors,
Diffundieren der Dotierung, die in der ersten Siliziumschicht (23) in der zugrundeliegenden epitaktischen Schicht enthalten ist, um die extrinsische Basis des Bipolartransistors zu bilden,
Implantieren einer Kollektordotierung vom n-Typ (30),
Implantieren einer Dotierung vom p-Typ (33), um die intrinsische Basis des Bipolartransistors zu bilden,
Abscheiden einer dritten Siliziumnitridschicht (40), Abscheiden einer zweiten Schicht aus Polysilizium (43), anisotropes Ätzen der zweiten Polysiliziumschicht, um Abstandhalter in den vertikalen Teilen davon übrig zu lassen, und Entfernen der sichtbaren Teile der dritten Schicht aus Siliziumnitrid,
Abscheiden einer dritten n-dotierten Polysiliziumschicht (46) und Diffundieren der Dotierung, um den Emitter des Bipolartransistors zu bilden,
Abscheiden einer planarisierten Isolierungsschicht (51), und Durchführen der Metallisierungen (53 - 56).

2. Verfahren nach Anspruch 1, **dadurch gekennzeichnet, dass** die erste Schicht aus Siliziumoxid (21) eine Dicke von rund 20 nm aufweist und die erste bis dritte Siliziumnitridschicht (22, 20, 40) eine Dicke von rund 30 nm aufweisen.

3. Verfahren nach Anspruch 1, **dadurch gekennzeichnet, dass** die erste Siliziumschicht (23) eine Dicke von rund 200 nm aufweist und die zweite Siliziumoxidschicht (24) eine Dicke von rund 300 nm aufweist.

4. Verfahren nach Anspruch 1, **dadurch gekennzeichnet, dass** die erste Siliziumschicht (23) mittels Abscheidens von undotiertem amorphen Silizium und dann mittels oberflächlichen Implantierens von BF₂ erlangt wird.

5. Verfahren nach Anspruch 1, **dadurch gekennzeichnet, dass** während des Schritts des Öffnens der ersten p-dotierten Polysilizium- oder amorphen Siliziumschicht (23), der zweiten Siliziumnitridschicht (20) und der zweiten Verkapselungsoxidschicht (24) eine Öffnung in der Verkapselungsoxidschicht (24) ausgebildet wird, die weiter als in der zweiten Siliziumnitridschicht (20) ist, wodurch diese Schicht auf ein Abscheiden der dritten Siliziumnitridschicht (40) hin eine größere Kontaktoberfläche mit der zweiten Siliziumnitridschicht (20) aufweist.

6. Verfahren nach Anspruch 1, **dadurch gekennzeichnet, dass** es vor dem Schritt des Abscheidens der dritten n-dotierten Polysiliziumschicht (46) ferner den Schritt aufweist, der in einem Ausbilden einer Öffnung in der zweiten Verkapselungsoxidschicht (24) besteht, um einen Teil der zweiten Siliziumnitridschicht (20) freizulegen, wodurch auf der Ebene dieser Öffnung die erste (23) und die dritte (46) Polysiliziumschicht einen Kondensator bilden, dessen Dielektrik aus einen Teil der zweiten Siliziumnitridschicht (20) gebildet ist.

7. Verfahren nach Anspruch 6, **dadurch gekennzeichnet, dass** diese Öffnung oberhalb eines dicken Oxidbereichs (5) ausgebildet ist.
